(19) Europäisches Patentamt
European Patent Office
Office européen des brevets

(11) **EP 2 234 304 B1**

(12) **EUROPEAN PATENT SPECIFICATION**

(45) Date of publication and mention
of the grant of the patent:
**02.01.2013 Bulletin 2013/01**

(51) Int Cl.:
*H04L 1/00* *(2006.01)*   *H03M 13/00* *(2006.01)*

(21) Application number: **09155597.9**

(22) Date of filing: **19.03.2009**

(54) **Method for recovery of lost and/ or corrupted data**

Verfahren zur Wiederherstellung von verlorenen bzw. beschädigten Daten

Procédé de récupération de données perdues et/ou corrompues

(84) Designated Contracting States:
**AT BE BG CH CY CZ DE DK EE ES FI FR GB GR HR HU IE IS IT LI LT LU LV MC MK MT NL NO PL PT RO SE SI SK TR**

(43) Date of publication of application:
**29.09.2010 Bulletin 2010/39**

(73) Proprietor: **Deutsches Zentrum für Luft- und Raumfahrt e.V.**
**51147 Köln (DE)**

(72) Inventor: **Dr. Liva, Gianluigi**
**81243, Munich (DE)**

(74) Representative: **von Kreisler Selting Werner Deichmannhaus am Dom**
**Bahnhofsvorplatz 1**
**50667 Köln (DE)**

(56) References cited:
**WO-A-2007/092214    US-A1- 2005 219 070**

- **RIZZO L: "EFFECTIVE ERASURE CODES FOR RELIABLE COMPUTER COMMUNICATION PROTOCOLS" COMPUTER COMMUNICATION REVIEW, ACM, NEW YORK, NY, US, vol. 27, no. 2, 1 April 1997 (1997-04-01), pages 24-36, XP000696916 ISSN: 0146-4833**
- **AMIN SHOKROLLAHI: "Raptor Codes" INTERNET CITATION, [Online] XP002367883 Retrieved from the Internet: URL:http: //www.cs.huji.ac.il/labs/danss/p2 p/resources/ raptor.pdf> [retrieved on 2006-02-15]**
- **JOHN W BYERS ET AL: "A Digital Fountain Approach to Asynchronous Reliable Multicast" IEEE JOURNAL ON SELECTED AREAS IN COMMUNICATIONS, IEEE SERVICE CENTER, PISCATAWAY, US, vol. 20, no. 8, 1 October 2002 (2002-10-01), XP011065538 ISSN: 0733-8716**

## Description

The present invention relates to a method for recovery of lost and/ or corrupted data which is transmitted from a transmitter device to a receiver device. The inventive method particularly deals with recovery of data which has been coded by the use Fountain codes or Raptor codes.

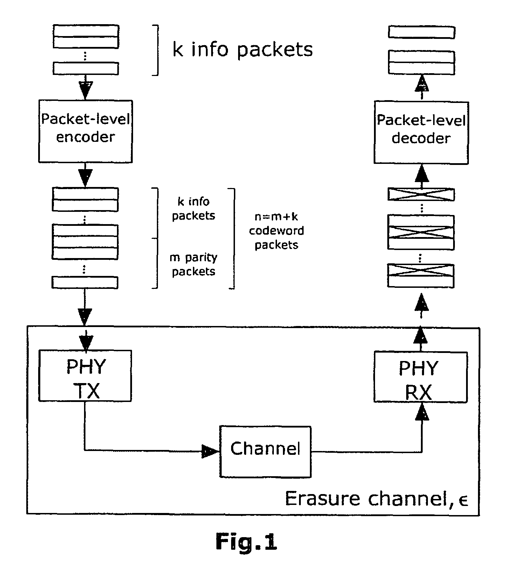

The basic problem which is addressed in this application deals with performance improvement on so called erasure channels. Beside the application of coding at physical layer, recently an increasing amount of research has been dedicated to the so called packet erasure channel (PEC). For example a communication system transmitting packets can be considered. The packets are protected at physical layer by an error correcting code (for example a turbo code) and by an error detection code (for example a CRC) in order to discard corrupted packets. At the layers above the physical one packets are either received correctly or are lost (namely erased, once the CRC on physical layer detects a corrupted packet). Thus from the upper layers the channel is seen as erasure channel with the transmission units that are packets. This situation is depicted in figure 1.

In this scenario the packet-level code is based on the encoding (on the transmitter side) of $k$ information packets into $n = k + m$ codeword packets. The codeword packets are then sent on the channel. On the receiver side, the missing information packets can be recovered by using the redundant ones properly. The encoding procedure is usually done bit-wise (or byte-wise) by using the encoder of a generic linear block code or a fountain code. The decoding is then performed by solving the system of equations defined by the parity-check matrix or decoding matrix of the code.

In "Systematic encoding and decoding of chain reaction codes, M. Amin Shokrollahi et al, US patent number: 6,909,383" and "J. Byers, M. Luby, M. Mitzenmacher, and A. Rege, - A digital fountain approach to reliable distribution of bulk data - in Proc. Of ACM SIGCOMM, 1998" a new concept is provided. Here, the packet-level encoder, instead of encoding the $k$ information packets in a fixed amount of codeword packets, is allowed to produce an infinite amount of redundancy, i.e., the code is defined as rate-less. The idea behind this invention is that in a broadcasting scenario, where many users try to retrieve a common message (e.g. a file) from a server, the server is a kind of fountain encoder, which produces redundant packets in a continuous manner. Each user, which is connected to the server via a wireless unreliable link, will receive some packets, while others will be lost. If a user receives a sufficient amount of redundant packets, he is able to recover the original message composed by $k$ packets. When a user accomplishes this task, a proper signal is sent to the fountain encoder. Once all the users have sent their acknowledgement, the fountain encoder stops producing redundant packets, and starts a new "fountain" session with another message.

This "fountain" concept is of great interest for broadcasting networks since it can be used to replace any type of ARQ (automatic repeat request). Suppose in fact that each user sends, on the contrary, a retransmission request to the server for each missing packets. It is indeed clear that, if many users are trying to retrieve the file from the server, the transmitter on the server side would be crowded by retransmission requests, making the overall efficiency of the link very low.

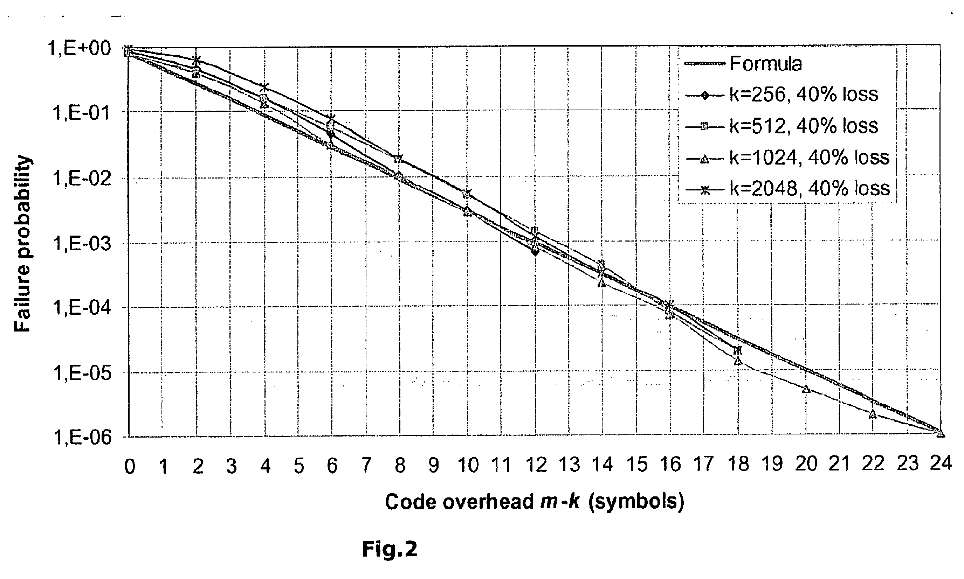

An ideal "Fountain" code is therefore a Fountain code which allows successful message recovery by the users with a minimum amount of packet transmissions, which is given by $k$. An efficient type of Fountain codes is represented by Raptor codes. Performance in terms of decoding failure probabilities (or codeword error rates) vs. the overhead is provided in Figure 2. The overhead is defined as the number of received packets in excess respect to the minimum that an ideal Fountain code would require ($k$) for a successful recovery of the original message. Raptor codes have been standardized for the MBMS service of UMTS. Performance of Raptor codes of "3GPP TS 26.346 V6.1.0, - Technical specification group services and system aspects; multimedia broadcast/ multicast service; protocols and codecs- June 2005", taken from "Michael Luby, Tiago Gasiba, Thomas Stockhammer, and Mark Watson - Reliable Multimedia Download Delivery in Cellular Broadcast Networks - IEEE TRANSACTIONS ON BROADCASTING, VOL. 53, No. 1, March 2007", are depicted in Figure 2. Note that an ideal Fountain code would achieve failure error rate 0 with overhead 0.

Thus it is an object of the present invention to provide a method for recovery of lost and/ or corrupted data whereby the overhead of information or data which is needed to recover the data is reduced.

This object is achieved by a method according to claim 1.

The inventive method for recovery of lost and/ or corrupted data transmitted from a transmitter device to a receiver device comprises the following steps:

- First the data is encoded by means of an encoder connected to the transmitter device.

- Then said data is transmitted from the transmitter device to the receiver device via a transmission system. A transmitter device as defined in the context of the present invention is any device which is suitable for transmission of data from the transmitter device to the receiver device and/ or vice versa. For instance the transmitter device can be provided by using a mobile broadcasting system (for example DVB-H or MBMS). Further the transmission of data can be performed by UMTS for instance. The transmitted data is decoded by means of a decoder which is connected to the receiver device wherein lost and or corrupted data is restored during decoding.

According to the invention encoding is performed by using a Fountain code (namely an encoding matrix A) and decoding is performed by solving the system of equations defined by the decoding matrix of the code. In Fountain or Raptor codes the encoding and decoding matrix are the same.

According to the state of the art the matrix is binary meaning that each entry of this matrix can be 0 or 1. According to the invention the encoding/ decoding matrix instead of being binary is built in a way that each non-null entry is replaced by an element taken from a Galois field of order $q$, whereby $q>2$, excluding the 0-element of the Galois field. This means in other words that the matrix used in the current invention comprises entries which can be 0, 1, 2, 3, 4 depending on the value of $q$. For example $q$ can be 4. By replacing the non-null elements of the binary matrix with entries of a higher order the probability that the above mentioned system of equations is full-rank is increased, and therefore the probability that the system of equations can be solved is increased, since the number of linear independent rows is increased. Of course the complexity of the operations is slightly increased whenever a higher-order Galois field is used. Nevertheless if for example rather small block sizes ($k$) are used, (with $k \leq 200$) although the complexity increases, it is still possible to keep the decoding feasible.

With the inventive method it is therefore possible to minimize the overhead which is required to restore lost or corrupted data.

The selection of the elements of the Galois field which replace each non-null entry of the parity-check matrix can be performed randomly.

It is preferred that encoding and decoding is performed by using a Fountain code, in particular a linear random Fountain code or a Raptor code.

In a preferred embodiment the extension of a binary code to a higher order Galois field with $q>2$ comprises the following steps:

- First the binary encoding/ decoding matrix of a code, for example a linear Fountain code or a Raptor code is built.

- Each non-null entry of the binary matrix is replaced by an element taken from a Galois field of order $q$ with $q>2$, excluding the 0-element of the Galois field.

- Then the encoding steps are performed by multiplication with submatrices ($G_{LDPC}$, $G_H$, $G_{LT}$) which are not more binary, on the Galois field with $q>2$ instead of the binary field.

The invention is further related to the use of the described method in a wireless or wired transmission system, in particular in a UMTS or MBMS scenario.

Preferred embodiments of the invention are now described on the basis of the following figures.

Figure 1 shows a flow diagram of the data transmission between a transmitter device a receiver device as practicable also in the method of the invention.

Figure 2 shows the performance of a Raptor code as a function of the overhead with various numbers of input packets $k$.

Figure 3 shows a Raptor encoder structure which can be used in the present invention.

Figure 4 shows the structure of the encoding matrix A for an ($n, k$) Raptor code as specified in the invention ($L = k + s + h$).

Figure 5 shows the performance of binary and quaternary (4-ary) Raptor codes according to the invention.

Figure 6 shows the codeword error rate vs. the overhead or $q$-ary linear random Fountain and Raptor codes with $k = 64$.

On the following pages it will be shown that for short input-block size binary and non binary Raptor codes provide performance close to those of random Fountain codes. Since random Fountain codes take a large advantage from higher order Galois fields it is preferred that non binary Raptor codes are used for those applications which require extreme erasure correction capabilities.

Fountain codes have been introduced in the state of the art as an efficient means for information delivery in broadcast/ multicast networks. A fountain code is usually employed to produce an undefined amount of redundant symbols out of a set of $k$ information symbols, which represent the source block. In broadcast/ multicast networks, each user collects the symbols produced by the fountain encoder (note that some of them may be lost due to physical layer decoding failures). Once a sufficient amount of symbols have been received, the user will be able to recover the $k$ information symbols. For an ideal Fountain code, this amount coincides with $k$, i.e., from any set of $k$ symbols the fountain decoder is able to recover the source block. Nevertheless, real fountain codes allow recovering the source block with a certain probability that depends on the number of symbols received in surplus respect to $k$. This number is usually referred to as the overhead $\delta$.

In this application, focus is laid on two specific classes of Fountain codes: random linear Fountain codes and Raptor codes. Raptor codes have been introduced as an instance of Fountain codes with low decoding complexity.

Random linear fountain codes have a decoding complexity that is $O(k^3)$. For both the method preferably relies on maximum-likelihood (ML) decoding.

In the following sections the performance of linear random Fountain codes whose symbols are taken from non-binary Galois fields will be specified. It will be shown that by allowing the code construction of a higher order field, the probability of success can be increased when the same overhead is considered. Non-binary Raptor codes will be introduced then, showing that they tightly match the random codes performance for small $k$.

In the packet broadcast context, the adoption of high order Galois fields does not necessarily impact the latency of the blocks on which fountain codes work. Fountain codes are used to generate redundant packets out of a source block of $k$ information packets. Suppose that the packet size is $T$. When binary fountain codes are used, bitwise operations at the encoder and decoder sides are performed $T$ times, all along the packet length. When a $q$-ary fountain code is used, $(\log_2 q)$-bits-wise operations at the encoder and decoder sides are performed $(T/\log_2 q)$ times, all along the packet length. What changes is the complexity of the operations, which is of course increased whenever an high-order Galois field is used. Preferably rather small block sizes are used, where although the complexity increases, it is still possible to keep the decoding feasible. Moreover, when the block size becomes small, savings in the already excellent overhead of binary Raptor codes binary Raptor codes can be achieved.

Let $U$ be the uniform distribution on $F_q^k$. The $q$-ary Fountain code $(k, U)$ is referred as a *random* Fountain code, and hence it is a linear map $F_q^k \rightarrow F_q^N$, where $F_q^N$ represents the set of all sequences over $F_q$. Roughly speaking, a $q$-ary random fountain code generates a j $^{th}$ output symbols $e_j$ as follows:

- For each input symbol $c_i \in F_q$, $i = 1... k$, a coefficient $h_{ji}$ is picked with a uniform probability in $F_q$.

- The output symbol $e_j$ is computed as $e_j = \sum_{i=1}^{k} h_{ji} c_i$, where all the operations are performed over $F_q$.

The fountain decoder collects the received symbols. Suppose that $r \geq k$ symbols are available at the receiver, and define $I = \{j$ s.t. $e_j$ has been received$\}$ as the set of indexes of the received symbols. Define moreover

$$H \triangleq \begin{bmatrix} h_{j1} h_{j2} h_{j3} \cdots h_{jk} \end{bmatrix}, j \in I$$

$H$ possesses $r$ rows. The fountain decoder will be able to recover the $k$ source symbols whenever $H$ has rank $k$. The average codeword error probability (e.g., the probability that the decoder does not succeed in the erasure recovery) of a random linear fountain code is therefore given by

$$P_e(r, k, q) = 1 - \prod_{i=1}^{k}\left(1 - \frac{q^{i-1}}{q^r}\right)$$

(1)

Let us denote for $= k$ and for $k \rightarrow \infty$,

$$P_e^\infty(q) \triangleq \lim_{k \to \infty} P_e(k, k, q) = 1 - c$$

(2)

where c is a constant which depends on $q$ and which represents the probability that an $k \times k$ matrix defined over $F_q$ is fullrank, for very large $k$. It can be noted that $c$ is monotonically increasing with $q$. Examples are $c(2) \simeq 0.28879$, $c(4) \simeq 0.688538$, $c(8) \simeq 0.859406$, $c(16) \simeq 0,933595$ etc ... There is an advantage in terms of performance due to the adoption of an higher order Galois field: already by switching from $F_2$ to $F_4$, in case of overhead $\delta \simeq r - k = 0$ the error probability would be roughly halved, dropping from 0.7112 to 0.3115. For a fixed overhead $\delta$, the following bound holds

$$P_e(\delta, k, q) = 1 - \prod_{i=1}^{k}\left(1 - \frac{q^{i-1}}{q^{k+\delta}}\right) \le \lim_{k \to \infty} P_e(\delta, k, q)$$

$$(3)$$

and that already for rather small values of $k$ (e.g. $k = 10$), $P_e(\delta, k, q) \approx \lim_{k-\infty} P_e(\delta, k, q)$ over a wide range of overheads.

In the following Raptor codes over GF($q$) are described. First the binary setting is discussed which then will be extended to the none binary case.

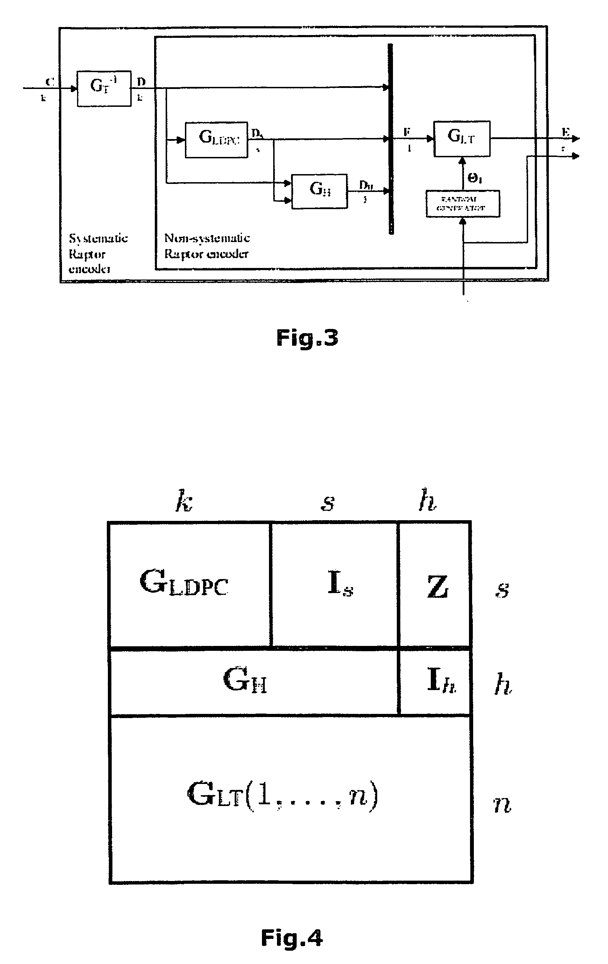

A Raptor code is obtained by a concatenation of an outer, high rate code, with an inner Luby-transform (LT) code as described in "M. Luby - LT codes- in Prc. of the 43rd Annual IEEE Symposium on Foundation of Computer Science, Vancouver, Canada, Nov. 2002, pp.271-282". A Raptor encoder is depicted in Figure 3. The most-inner code is a non systematic LT code with $L$ input symbols $F$, producing the encoded symbols $E$. The symbols F are known as *intermediate symbols,* and are generated through a pre-coding, made up of some outer high-rate block coding, effected on the $k$ symbols $D$. The $s$ intermediate symbols $D_s$ are known as *LDPC symbols,* while the $h$ intermediate symbols $D_h$ are known as *half symbols.* The combination of pre-code and LT code produces a non systematic Raptor code. The parameters $s$ and $h$ are functions of $k$. The non-systematic Raptor encoding turns in a systematic one by using a rate-1 linear pre-code generating the $k$ symbols $D$ from the $k$ information symbols of the source block $C$.

A unique encoded symbol ID (ESI) is assigned to each encoded symbol. Starting from an ESI $i$, the encoded symbol $E_i$ is computed by xor-ing a subset $\Theta_i$ of $d_i$ intermediate symbols. The number $d_{it}$ known as the *degree* associated with the encoded symbol $E_{it}$ is a random integer between 1 and $L$: the $d_i$ intermediate symbols are chosen at random according to a specific probability distribution. As a consequence, in order to recover the information symbols the decoder needs both the set of encoded symbols $E_i$ and of the corresponding $\Theta_i$. This last information can either be explicitly transmitted or obtained by the decoder through the same pseudo-random generator used for the encoding, starting from ESIs, which have therefore to be sent together with the corresponding encoded symbols.

Now Raptor encoding and decoding will be described.

The set of constraints involving the symbols produced by the Raptor encoder can conveniently be represented as:

$$A \cdot F = \begin{bmatrix} 0 \\ E[1,..,n] \end{bmatrix}$$

whereby $A$ is a $((s + h + n) \times (s + h + k))$ binary matrix called *encoding matrix,* whose structure is shown in Fig. 4. In this figure, $I_s$ is the $(s \times s)$ identity matrix, $I_h$ is the $(h \times h)$ identity matrix and $Z$ is the $(s \times h)$ all-zero matrix. The matrix A doesn't properly represent the Raptor code generator matrix, but includes the set of constraints imposed by the pre-coding and LT coding together. The notation A $(j_1, j_2, ..., j_r)$ is used to indicate the $((s + h + r) \times L)$ sub-matrix of A obtained by selecting only the rows of $G_{LT}$ with indexes $(j_1, j_2, ...,j_r)$. Again, A is equivalent to A $(1, ..., n)$.

A possible Raptor encoding algorithm exploits a sub-matrix of A. Such a matrix, consisting of the first $L$ rows of A, is used to obtain $F$ solving the system of linear equations:

$$A(1,...,k) \cdot F = \begin{bmatrix} 0 \\ C \end{bmatrix}.$$

At this point it is sufficient to multiply $F$ by the LT generator matrix to produce the encoded symbols $E$.

It is now explained how to perform ML decoding for Raptor codes. The first decoding step will turn into solving

$$A(j_1, j_2, ..., j_r) \cdot F = \begin{bmatrix} 0 \\ E[j_1, j_2, ..., j_r] \end{bmatrix}$$

$$(4)$$

where A $(j_1, j_2, ..., j_r)$ is a $((s + h + r) \times L)$ matrix, as defined above, and the generic $j \in I$. Efficient ML decoding of Raptor codes is possible thanks to a class of algorithms performing a structured Gaussian elimination A $(j_1, j_2, j_r)$. The system can be solved only if $s + h + r \geq L.$, that is $r \geq k$ (note that this is a necessary condition for successful decoding, not a sufficient one). Once $F$ is known, the source symbols can be recovered by $C = G_{LT} (1,..., k) \cdot F$.

Raptor codes on higher order Galois fields can be derived from their binary counterpart, by slightly generalizing their construction. Loosely speaking, to obtain a $q$-ary Raptor code it is sufficient to replace each non-null entry of the matrix A with an element picked uniformly at random in $F_q \setminus \{0\}$. On encoder side, this implies that the output symbols are not just obtained by bit-wise summing given sequences of input symbols. They are still indeed linear combinations of input symbols, where input symbols are $(\log_2 q)$-bits-wise multiplied by elements in $F_q$ and then summed over $F_q$. Similarly, the erasure recovery takes place by applying Gaussian elimination to (4), where the elements of A $(i_1, j_2, ..., j_r)$ belong to $F_q$.

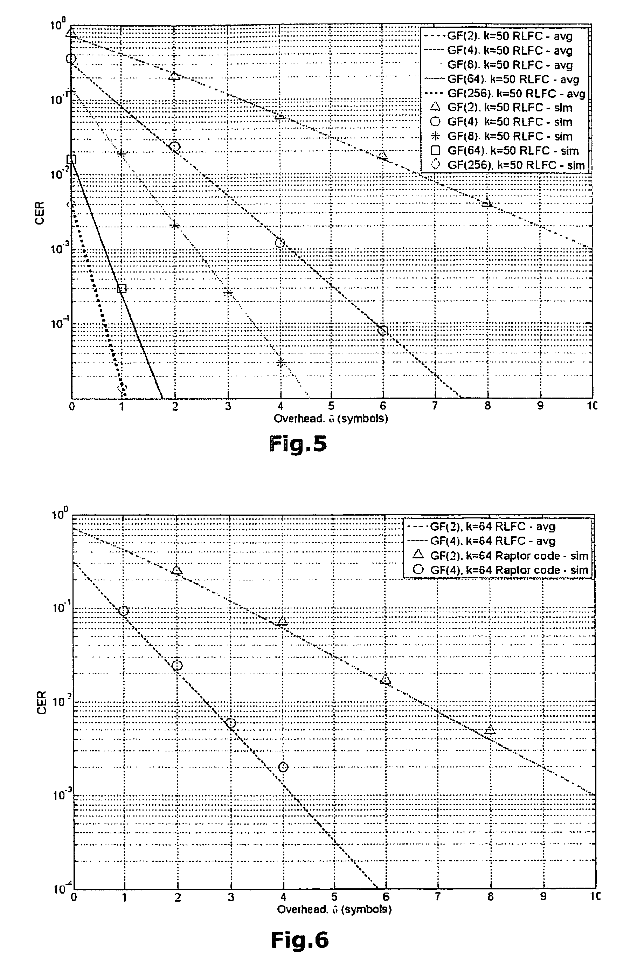

Some numerical results in terms of codeword error rate (CER) vs. overhead $\delta$ are provided next. In Figure 5 the average performance of random linear fountain codes with $k = 16$ are provided for $q = 2, 4, 8, 64$, and are compared to Montecarlo simulations for $q = 2$ and $q = 4$. Apart from the good match between the average ensemble performance and the simulated one, the main outcome of the analysis is the large performance gain achievable by high order random codes. Already by moving from $F_2$ to $F_4$, the overhead required to achieve CER = $10^{-3}$ is almost halved. Note that with just one symbol of overhead, a 64-ary random code achieves an average CER $\approx 3 \cdot 10^{-4}$. In Figure 6 the performance of a binary Raptor code with $k = 64$ is compared with that of its extension on $F_4$ (carried out according to the methodology introduced above). For sake of completeness, the average performance of random codes with $k = 64$ is provided as well. Remarkably, both the binary version and the 4-ary version of the $k = 64$ Raptor code tightly approach their random codes counterpart. The 4-ary Raptor code achieves CER $\approx 10^{-3}$ with 4-5 symbols of overhead, while the binary one needs almost $\delta = 10$ to reach the same error rate.

In this application, small-block-size Raptor codes have been compared to random fountain codes with both binary and non binary symbol alphabets. It has been shown how short Raptor codes are able to tightly match the performance of random codes, providing similar codeword error rates when the same overhead is considered. The advantage coming from the adoption of higher-order Galois fields in the code construction has been discussed and proved. Non-binary Raptor codes represent indeed an appealing solution for encoding small source blocks, allowing a remarkable reduction in the absolute overhead.

The inventive method can be used in relation with Fountain or Raptor codes.

## Claims

1. A method for recovery of lost and/or corrupted data transmitted from a transmitter device (10) to a receiver device (12), said method comprising the steps of:

   coding said data by means of an encoder (14) connected to the transmitter device (10),
   transmitting said data from the transmitter device (10) to the receiver device (12) via a transmission system (18), and
   decoding said data, by means of a decoder (16) connected to the receiver device (12), wherein lost and/or corrupted data is restored during decoding,
   whereby encoding is performed by using a Fountain code and decoding is performed by solving the system of equations defined by the decoding matrix (A) of the code,
   **characterized in that**
   the encoding/ decoding matrix (A) instead of being binary is built in a way that each non-null entry is replaced by an element taken from a Galois field of order $q$, whereby $q>2$, excluding the 0-element of the Galois field.

2. The method according to claim 1, **characterized in that** the selection of the element of the Galois field which replaces each non-null entry of the encoding/ decoding (A) is performed randomly.

3. The method according to claim 1 or 2, **characterized in that** encoding and decoding is performed by using a Fountain code, in particular a linear random Fountain code.

4. The method according to any one of claims 1 or 3, **characterized in that** encoding and decoding is performed by using Raptor codes.

5. The method according to any one of claims 1 to 4, **characterized in that** the extension of a binary code to a higher order Galois field (GF($q$)) with $q>2$ comprises the following steps:

   - building the binary matrix (A) of a code, in particular of a linear Fountain code or Raptor code,
   - replacing each non-null entry of the binary matrix (A) by an element taken from a Galois field of order $q$ with $q>2$, excluding the 0-element of the Galois field and
   - performing the encoding steps by multiplication with submatrices ($G_{LDPC}$, $G_H$, $G_{LT}$) which are not more binary on the Galois field with $q>2$ instead of the binary field.

6. Use of the method according to any one of the claims 1 to 5 for a wireless or wired transmission system in a broadcasting or multicasting scenario in particular for a UMTS-application, in particular for the multimedia broadcast multicast service (MBMS).

**Patentansprüche**

1. Verfahren zur Wiederherstellung verlorener und/oder beschädigter Daten, die von einer Sendevorrichtung (10) an eine Empfängervorrichtung (12) übertragen wurden, wobei das Verfahren die folgenden Schritte aufweist:

   Codieren dieser Daten mittels eines Codierers (14), der mit der Sendevorrichtung (10) verbunden ist,
   Übertragen der Daten von der Sendevorrichtung (10) an die Empfängervorrichtung (12) über ein Übertragungssystem (18), und
   Decodieren dieser Daten mittels eines mit der Empfängervorrichtung (12) verbundenen Decodierers (16), wobei die verlorenen und/oder beschädigten Daten während des Decodierens wiederhergestellt werden,
   wobei das Codieren unter Verwendung eines Fountain-Codes und das Decodieren durch Lösen des Gleichungssystems erfolgt, das durch die Decodiermatrix (A) des Codes definiert ist,
   **dadurch gekennzeichnet, dass**
   die Codier-/Decodiermatrix (A), anstatt binär zu sein, derart aufgebaut ist, dass jeder von Null verschiedene Eintrag durch ein Element ersetzt wird, das aus dem Galois-Feld der Ordnung $q$ entnommen wird, wobei $q > 2$, unter Ausschluss des 0-Elements des Galois-Felds.

2. Verfahren nach Anspruch 1, **dadurch gekennzeichnet, dass** die Wahl des Elements des Galois-Felds, welches jeden von Null verschiedenen Eintrag der Codier-/Decodiermatrix (A) ersetzt, zufällig erfolgt.

3. Verfahren nach Anspruch 1 oder 2, **dadurch gekennzeichnet, dass** das Codieren und das Decodieren unter Verwendung eines Fountain-Codes, insbesondere eines Linear-Random-Fountain-Codes, durchgeführt werden.

4. Verfahren nach einem der Ansprüche 1 oder 3, **dadurch gekennzeichnet, dass** das Codieren und das Decodieren erfolgen unter Verwendung von Raptor-Codes.

5. Verfahren nach einem der Ansprüche 1 bis 4, **dadurch gekennzeichnet, dass** die Erweiterung eines binären Codes zu einem Galois-Feld höherer Ordnung (GF($q$)) mit $q > 2$, die folgenden Schritte aufweist:

   - Erstellen der binären Matrix (A) eines Codes, insbesondere eines linearen Fountain- oder Raptor-Codes,
   - Ersetzen jedes von Null verschiedenen Eintrags der binären Matrix (A) durch ein Element, das aus dem Galois-Feld der Ordnung $q$ entnommen wird, wobei $q > 2$, unter Ausschluss des 0-Elements des Galois-Felds, und
   - Durchführen der Codierschritte an dem Galois-Feld, bei welchem $q > 2$ ist, anstatt dem binären Feld durch Multiplikation mit Submatrizes ($G_{LDPC}$, $G_H$, $G_{LT}$), welche nicht mehr binär sind.

6. Verwendung des Verfahrens nach einem der Ansprüche 1 bis 5 für ein drahtloses oder drahtgebundenes Übertragungssystem in einem Broadcasting- oder Multicasting-Szenario, insbesondere für eine UMTS-Anwendung, insbesondere für den Multimedia-Broadcasting-Multicasting-Service (MBMS).

**Revendications**

1. Procédé de récupération de données perdues et/ou corrompues transmises à partir d'un dispositif émetteur (10) vers un dispositif récepteur (12), ledit procédé comportant les étapes comprenant le fait de :

   coder lesdites données au moyen d'un encodeur (14) connecté au dispositif émetteur (10),
   transmettre lesdites données à partir du dispositif émetteur (10) vers le dispositif récepteur (12) par l'intermédiaire d'un système de transmission (18), et
   décoder lesdites données au moyen d'un décodeur (16) connecté au dispositif récepteur (12), dans lequel les données perdues et/ou corrompues sont restaurées pendant le décodage,
   de sorte que le codage est exécuté en utilisant un code Fontaine et que le décodage est exécuté en résolvant le système d'équations défini par la matrice de décodage (A) du code,

   **caractérisé en ce que**
   la matrice de codage/décodage (A) au lieu d'être binaire est construite de manière à ce que chaque entrée non nulle soit remplacée par un élément prélevé à partir d'un champ de Galois d'ordre $q$ , de sorte que $q > 2$, en excluant l'élément 0 du champ de Galois.

2. Procédé selon la revendication 1, **caractérisé en ce que** la sélection de l'élément du champ de Galois qui remplace chaque entrée non nulle du codage/décodage (A) est réalisée de façon aléatoire.

3. Procédé selon la revendication 1 ou 2, **caractérisé en ce que** le codage et le décodage sont réalisés en utilisant un code de Fontaine, en particulier un code Fontaine linéaire aléatoire.

4. Procédé selon l'une quelconque des revendications 1 ou 3, **caractérisé en ce que** le codage et le décodage sont réalisés en utilisant des codes Raptor.

5. Procédé selon l'une quelconque des revendications 1 à 4, **caractérisé en ce que** l'extension d'un code binaire à un champ de Galois d'ordre plus élevé (GF(q)) avec q > 2 comporte les étapes suivantes :

   - construire la matrice binaire (A) d'un code, en particulier d'un code Fontaine linéaire ou d'un code Raptor,

   remplacer chaque entrée non nulle de la matrice binaire (A) par un élément prélevé à partir d'un champ de Galois d'ordre $q$ avec $q > 2$, en excluant l'élément 0 du champ de Galois et
   exécuter les étapes de codage par multiplication avec les sous-matrices ($G_{LDPC}$, $G_H$, $G_{LT}$) qui ne sont plus binaires sur le champ de Galois avec $q > 2$ à la place du champ binaire.

6. Utilisation du procédé selon l'une quelconque des revendications 1 à 5 pour un système de transmission sans fil ou de transmission câblée dans un scénario de diffusion ou de diffusion groupée en particulier pour une application UMTS, en particulier pour le Service Multidestinataire de Diffusion Multimédia (MBMS).

k info packets

Packet-level encoder

k info packets

m parity packets

n=m+k codeword packets

PHY TX

Packet-level decoder

PHY RX

Channel

Erasure channel, ϵ

**Fig.1**

Fig.2

**Fig.3**

**Fig.4**

Fig.5

Fig.6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6909383 B, M. Amin Shokrollahi

### Non-patent literature cited in the description

- **J. BYERS ; M. LUBY ; M. MITZENMACHER ; A. REGE.** A digital fountain approach to reliable distribution of bulk data. *Proc. Of ACM SIGCOMM,* 1998
- Technical specification group services and system aspects; multimedia broadcast/ multicast service; protocols and codecs. *3GPP TS 26.346 V6.1.0,* June 2005
- **MICHAEL LUBY ; TIAGO GASIBA ; THOMAS STOCKHAMMER ; MARK WATSON.** Reliable Multimedia Download Delivery in Cellular Broadcast Networks. *IEEE TRANSACTIONS ON BROADCASTING,* March 2007, vol. 53 (1
- **M. LUBY.** LT codes. *Prc. of the 43rd Annual IEEE Symposium on Foundation of Computer Science,* November 2002, 271-282